(19) **Europäisches Patentamt**
**European Patent Office**
**Office européen des brevets**

(11) **EP 2 230 664 B1**

(12) **EUROPEAN PATENT SPECIFICATION**

(45) Date of publication and mention
of the grant of the patent:
**29.06.2011 Bulletin 2011/26**

(51) Int Cl.:
*G10L 21/02* (2006.01)          *H03G 3/34* (2006.01)
*H03G 3/20* (2006.01)          *H03G 3/30* (2006.01)

(21) Application number: **09004056.9**

(22) Date of filing: **20.03.2009**

(54) **Method and apparatus for attenuating noise in an input signal**

Verfahren und Vorrichtung zur Dämpfung von Rauschen in einem Eingangssignal

Procédé et appareil pour atténuer le bruit dans un signal d'entrée

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(43) Date of publication of application:
**22.09.2010 Bulletin 2010/38**

(73) Proprietor: **Harman Becker Automotive Systems
GmbH
76307 Karlsbad (DE)**

(72) Inventors:
• **Iser, Bernd
89077 Ulm (DE)**
• **Schmidt, Gerhard
89081 Ulm (DE)**
• **Roder, Mathias
61231 Bad Nauheim (DE)**

(74) Representative: **Grünecker, Kinkeldey,
Stockmair & Schwanhäusser
Anwaltssozietät
Leopoldstrasse 4
80802 München (DE)**

(56) References cited:
**WO-A1-96/13096          JP-A- 2003 052 096
US-A- 4 628 529          US-A- 6 094 490
US-A1- 2009 010 452**

• **WESTERLUND N ET AL: "Speech enhancement
for personal communication using an adaptive
gain equalizer" SIGNAL PROCESSING,
ELSEVIER SCIENCE PUBLISHERS B.V.
AMSTERDAM, NL, vol. 85, no. 6, 1 June 2005
(2005-06-01), pages 1089-1101, XP004862725
ISSN: 0165-1684**

**Description**

The invention is directed to a method and an apparatus for attenuating noise in an input signal.

In a variety of situations, signals may be a way of transmitting information between two communication partners. There are different kind of signals in use, including electric signals, radio signals, light signals and sound signals. Besides a wanted signal component carrying the information to be transmitted, signals may comprise noise. In particular, in a telephone system, the sound signal from a user is transformed at the sender side into an electric signal, the electric signal is forwarded via electronic components of a telephone network to a receiver and is there transformed back by electronic components into a wanted sound signal. If noise is present in the electric signal to be transformed at the receiver side, then artifacts are audible in the resulting sound signal. Noise may have been added to the electric signal generated at the sender side by electronic components in the telephone network. Such components may generate noise even at times where no wanted signal component is present at all and the resulting noise will be noticeable as artifact by the user particularly during pauses of the wanted signal. One example for electronic components generating noise in a network are network access devices (NADs) or network access modules (NAMs).

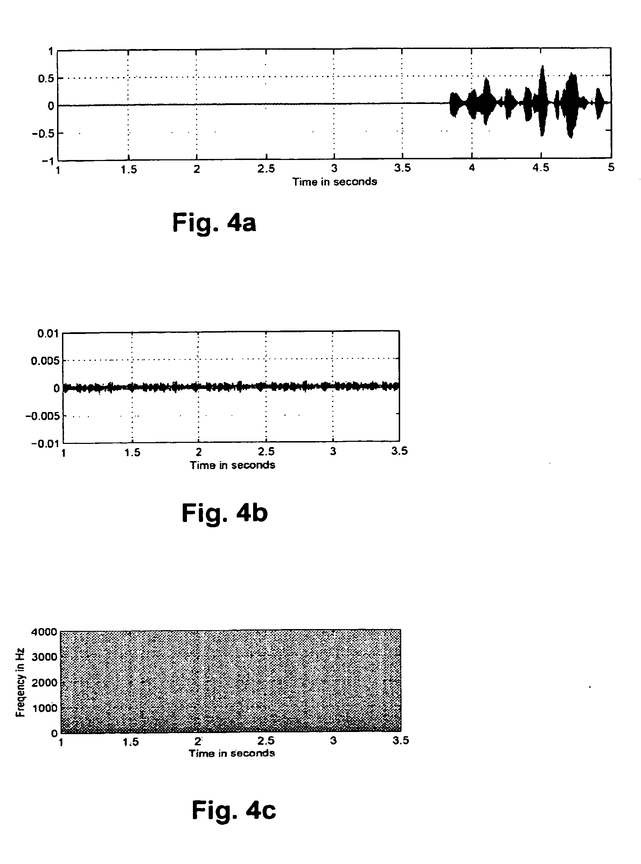

Figure 4 shows the intensity of a measured output signal of a NAD. While a wanted signal component starts shortly before the 4th second, no signal seems to be present at earlier times according to the diagram of Figure 4a. However, if the scale for the intensity value is enlarged, which is illustrated in Figure 4b, a noise component can be recognized at times between second 1 and 3.5 while no wanted signal component is present. The noise component is illustrated in Figure 4c, showing a time-frequency analysis of the signal over the first few seconds. Hence, a user receiving a signal as in Figure 4a as an electric input signal to its telephone system would hear the sound of the noise during an initial period whereas no wanted signal is received from the remote partner.

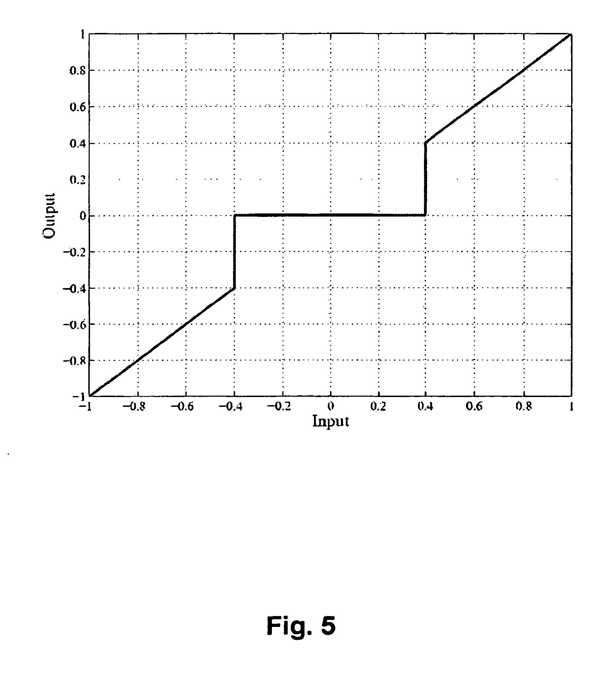

Several approaches have been followed to prevent the problem of an interfering noise component, particularly during times where no wanted signal component is present. One of these approaches is the use of a noise gate. A noise gate has the property of suppressing all input signals whose level is below a certain threshold. The principle of a noise gate is illustrated by Figure 5. Here, an input signal with an intensity level below a gate threshold with an absolute value of 0.4 results in an output of level 0, i.e. no output at all, while an input signal with an intensity level above the gate threshold passes with unchanged intensity. However, while a signal whose intensity is below the gate threshold is filtered out, a wanted signal component is suppressed as well during intervals where the sum of the noise signal level and the wanted signal level is below the gate threshold. Hence, employing a noise gate has a deteriorating effect on the wanted signal component as well. An example of implementation of such a noise gate is given in US 2009/0010452.

Another approach to the problem of suppressing noise, particularly in pauses of a wanted signal, is the use of a squelch function. This function is preferably included into amateur radio receivers and has the effect that the wanted low frequency signal is forwarded to the low frequency amplifier by the intermediate frequency amplifier only if the intermediate frequency signal exceeds a predetermined level. But the wanted signal is also affected here in situations when only a small input signal is present and the predetermined level is not exceeded by the intermediate frequency signal.

Employing a Wiener-type filter is a further method of suppressing noise. However, the Wiener filter is adapted to suppressing noise activities during speech activity by taking into account the spectral characteristics of noise and of a speech signal. However, no assumptions about the spectral distribution of the noise may be made in general, particularly of the noise that is created by electronic components, and also, the wanted signal is not restricted to a speech signal. However, with a signal other than a speech signal and a spectral distribution of the noise other than that assumed for a noisy environment of the speaker, the Wiener filter is less effective in the task of discerning between noise and speech and hence, the wanted signal will in general be affected to some degree by a Wiener filter as well. Furthermore, Wiener-type filters usually introduce some delay, which is undesired.

Other methods for suppressing noise which take into account the spectral characteristics of noise and of a speech signal belong to the class of spectral subtraction methods. The application US 4628529 describes an implementation of such a spectral subtraction procedure.

Hence, there is a need for a method of attenuating a noise component in an input signal, which has less effect on a wanted signal component than the methods presently in use.

In view of this need, this invention provides a method according to claim 1 and a system according to claim 13.

In particular, the invention provides a method of attenuating noise in an input signal, comprising the steps of:

(a) receiving the input signal;

(b) estimating the power of the input signal to obtain an input power estimate;

(c) determining a noise power value based on the input power estimate, the noise power estimate corresponding to an estimate of the noise power within the input signal;

(d) determining an attenuation factor based on the noise power value; and

(e) attenuating the input signal by using the attenuation factor.

The invention provides a particular way of deriving an estimate for the power of the noise component in the input signal from the power of the input signal. This estimate may be used to determine an attenuation factor dynamically in dependence on the estimated power of the noise component. In this way, the invention permits to adapt its attenuation behavior to the presence of noise more effectively than prior methods. In particular, the invention permits to attenuate noise during pauses of a wanted signal component in the input signal, particularly in low noise conditions, with less deterioration of the wanted signal component, as it will more clearly discern between a wanted signal component with low power and noise.

The noise to be attenuated may be electronic noise. Electronic noise may be created by electronic components. Electronic components generating noise may be devices processing and/or amplifying acoustic or non-acoustic signals. In particular, such electronic components may be network access devices (NADs).

The input signal may comprise a noise component and a wanted signal component. When a wanted signal is processed by an electronic component, the electronic component may add a noise component to the wanted signal component. The method may be used to attenuate the noise component during periods where the input power estimate of the input signal does not exceed the noise power value multiplied by a predetermined factor. The method may be applied to identify pauses of the wanted signal component in the input signal. The noise may be strongly reduced during pauses, while at times where a wanted signal component is present, the attenuation may be adapted to avoid deteriorating the wanted signal component. Particularly, the wanted signal component may be a speech signal component.

The power of the input signal may be the modulus or the absolute value of the signal strength. Alternatively, the power of the input signal may be the square or the square of the modulus of the signal strenght of the input signal. Correspondingly, the noise power value may be the modulus or the absolute value of the signal strength of a noise component. Alternatively, the noise power value may also be the square or the square of the modulus of the signal strength of a noise component. There may be other ways of estimating the power of the input signal or the power of a noise component. The power of the input signal and the power of the noise component may be determined according to different ways.

The input signal may be an analog signal or a digital signal. If the received input signal is an analog signal, step (a) may comprise digitizing the input signal.

To digitize an analog signal, a parameter of the analog signal may be determined. Such a parameter may be the amplitude or the power of the input signal. The parameter of the signal may be determined at a plurality of successive times. In other words, the input signal may be sampled to obtain signal samples or samples. The successive times may be separated by an equal period of time. Each sample has a sample value corresponding to the respective signal parameter value, e.g. the respective amplitude or the power of the signal. The time at which a sample has been obtained is called the sample time. Samples may be ordered in time according to their sample times. A sequence of time-ordered samples may be called a digital signal.

A time-ordered sequence of samples may be divided into blocks of samples. A block of samples may comprise a fixed number of samples, or the number of samples in a block may be varying. In particular, a block may comprise only one sample. The input signal may be represented by a sequence of samples. The input signal may also be represented by a sequence of blocks which has been built from the sequence of samples. The corresponding sequence of blocks representing the signal may be ordered in time.

A block of samples may be assigned a block value representing the sample values in the block. The block value may be the average, or a weighted average, of the sample values of all or a part of the samples in the block, or may be the value of a selected sample from the block. Each block of samples may be assigned a block time representing the sample times of the samples in the block. The block time may be the sample time of one of the samples in the block (e.g. the first or the last one). The block time may be an average of the sample times of the samples in the block.

Alternatively, the input signal may be a digital input signal. The digital input signal may be represented by a time-ordered sequence of samples or of blocks of samples as in the case of an analog signal which has been digitized.

In step (b), the sequence of sample values or of block values representing the digital or digitized input signal may be smoothed in order to obtain the input power estimate. One sample or block of the smoothed sequence may correspond to one sample or block of the unsmoothed sequence and have the same sample time. For the smoothing, a first order Infinite Impulse Response (IIR) filter may be used. In this way, abrupt changes in the input signal are removed before further processing of the input signal takes place.

The input power estimate, the noise power value and the attenuation factor may be determined for a sample or for a block of samples, meaning that they are determined for the sample time of the sample or the block time of the block.

Step (c) may comprise determining whether the input power estimate at a given time is larger than the noise power value at a previous time. In addition or instead, step (c) may comprise determining whether the input power estimate at a given time is smaller than or equal to the noise power value determined at a previous time. The input power estimate may be determined for a sample or block of samples where the sample time or the block time is the given time. The noise power value may be determined for a sample or block of samples preceding the sample or block of samples whose sample time or block time is the given time. The preceding sample or block of samples may be directly preceding or may be separated by a predetermined number of samples or blocks. The time interval between the given time and previous time may comprise sample times or block times of a fixed or variable number of samples or blocks.

Step (c) may comprise increasing the noise power value at a given time if the input power estimate at the given time is larger than the noise power value at a previous time. The input power estimate may be determined for a sample or block of samples where the sample time or the block time is the given time. The noise power value may be determined for a sample or block of samples preceding the sample or block of samples whose sample time or block time is the given time. The preceding sample or block of samples may be directly preceding or may be separated by a predetermined number of samples or blocks. The time interval between the given time and the previous time may comprise sample or block times of a fixed or variable number of samples or blocks. In addition or instead, the noise power value at the given time may be increased if the input power estimate at the given time is equal to the noise power value at the previous time.

Step (c) may also comprise decreasing the noise power value at a given time if the input power estimate at the given time is smaller than the noise power value at a previous time. The decreasing may be accomplished in a way corresponding to increasing the noise power value.

Step (c) may comprise determining the noise power value at a given time, based on the noise power value determined at a previous time, multiplied by an adjustment factor. The noise power value determined at a previous time may be determined for a sample or block of samples preceding the sample or block of samples whose sample time or block time is the given time. The preceding sample or block of samples may be directly preceding or may be separated by a predetermined number of samples or blocks. The time interval between the given time and the previous time may comprise sample or block times of a fixed or variable number of blocks of samples. The adjustment factor may be a constant, or may be time dependent. To permit adaptation of the method to a varying signal, the difference between the given time and the previous time may vary with time.

In step (c), the noise power value may be bounded below by a predetermined lower noise limit. The predetermined lower noise limit may be constant or time-dependent.

In step (c), determining a noise power value may be performed based on the input power estimate smoothed by a filter. The filter may be a Infinite Impulse Response (IIR) filter. The IIR filter may be of first order, or of a higher order. In particular, the noise power value may be equal to the input power estimate. Determining the noise power estimate based on the input power estimate smoothed by a filter may be performed for a single sample or block of samples having a sample time or a block time at a given time. It may be performed for a predetermined amount of samples or blocks of samples. The predetermined amount of samples or blocks may be the samples or blocks obtained directly after performance of the method has been started. Alternatively or in addition, determining the noise power estimate based on the input power estimate smoothed by a filter may be performed for a fraction of the samples or blocks for which the method is performed. The fraction of samples may be distributed regularly or irregularly over all the samples for which the method is performed.

Step (d) may be additionally based on the input power estimate. So, it becomes possible to react more flexibly to different input power levels.

Step (d) may comprise determining an indicator value indicating the presence of a wanted signal component in the input signal at a given time. The attenuation factor may be based on the indicator value. The indicator value may be based on the noise power value. The indicator value and/or the attenuation factor may be dependent on the input power estimate.

The indicator value may be increased if the input power estimate at the given time is smaller than the product of the noise power value at the given time and a predetermined sensitivity factor. The sensitivity factor may be a predetermined constant, or may vary with time. The sensitivity factor may be dependent on the maximum and/or the minimum value of the input power estimate and/or of the noise power value in a period of time. Increasing may comprise multiplying the indicator value determined at a previous time by a predetermined positive factor greater than one. The previous time may be the block time or the sample time of a block or sample which precedes the given time. The indicator value may also be increased if the input power estimate at the given time is equal to the product of the noise power value at the given time and the sensitivity factor.

The indicator value may be decreased if the input power estimate at the given time is smaller than the product of the noise power value at the given time and a predetermined sensitivity factor. The sensitivity factor may be a predetermined constant, or may vary with time. The sensitivity factor may be dependent on the maximum and/or the minimum value of the input power estimate and/or of the noise power value in a period of time. Decreasing may comprise multiplying the indicator value determined at a previous time by a predetermined positive factor smaller than one. The previous time may be the block time or the sample time of a block or sample which precedes the given time. The indicator value may also be decreased if the input power estimate at the given time is equal to the product of the noise power value at the given time and the sensitivity factor.

The indicator value may be bounded above by a predetermined indicator maximum value and/or may be bounded below by a predetermined indicator minimum value. The indicator maximum value may be a predetermined constant or may be a predetermined function of the time. The indicator minimum value may be a predetermined constant or may be a predetermined function of the time.

The indicator maximum value may be a predetermined function of the input power estimate and/or of the noise power estimate. If the signal power estimate is below the product of the noise power value and a sensitivity factor at a given time, the indicator value determined at a previous time may be increased and compared to the indicator maximum value. If the increased indicator value is above the indicator maximum value, then the indicator value may be set to the indicator maximum value.

The indicator minimum value may be a predetermined function of the input power estimate and/or of the noise power estimate. If the signal power estimate is below and/or equal to the product of the noise power value and the sensitivity factor at a given time, the indicator value determined at a previous time may be decreased and compared to the indicator minimum value. If the decreased indicator value is below the indicator minimum value, the indicator value may be set to the indicator minimum value.

The attenuation factor may be based on the quotient of the indicator value and the input signal estimate. The attenuation factor may be time dependent. The attenuation factor may be based on the quotient of the squared moduli of the indicator value and the input signal estimate. In this way, a more abrupt distinction between the presence and the absence of a wanted signal component may be obtained. The attenuation factor may be equal to the squared moduli of the indicator value and the input signal estimate.

The steps (b) to (e) may be repeated. All the steps (b) to (e) may be performed for one sample or block. In other words, all the steps (b) to (e) may be performed at the same sample time or block time. In particular, if the input signal is represented by a sequence of samples or blocks of samples, the steps (b) to (e) may be performed for each sample or block of samples in the sequence.

The input signal may comprise an acoustic wanted signal component. The input signal may be received from a microphone, from a device for reproducing recorded sound, like a CD- or a DVD player or a radio, or from a device giving spoken instructions to a user, like an electronic navigation device or a system issuing speech prompts. The input signal may be received from a network access module, particularly a network access module of a telephone network, or a radio network. The input signal may be received from a hands-free system. The input signal may be received from a system which is installed in a vehicular cabin.

The method may be performed in a device dealing with or processing acoustic signals, particularly in a communication device. Such a device may be a mobile telephone or a landline telephone, a hands-free system, a portable or stationary radio system or a system for controlling devices via voice control. The device may be installed in a vehicular cabin.

Step (e) may comprise multiplying the input signal by the attenuation factor. Multiplying the input signal may comprise multiplying each of the samples of the digital or digitized input signal with the attenuation factor. The attenuation factor may be applied to a single sample or to all or a part of the samples in one or more blocks of samples

The attenuation factor may be bounded below by a predetermined attenuation minimum value and bounded above by a predetermined attenuation maximum value, and/or the attenuation factor may be time dependent. The attenuation maximum and minimum values may be constant, or at least one of them may be time dependent. The attenuation maximum and minimum values may depend on the source for the input signal. Hence, it becomes possible to adapt the method more closely to the characteristics of the signal source. The attenuation factor may be time dependent. The attenuation factor may depend directly on the time, and/or the attenuation factor may depend on quantities which are time dependent. The attenuation factor may also be dependent on the input power estimate. Changes of the attenuation factor caused by changes of the indicator value may decrease with increasing input power estimate.

The invention further provides a computer program product comprising one or more computer-readable media having computer-executable instructions thereon for performing the steps of one of the methods described above when run on a computer. The methods described above may as a whole or in part be executed by a computer.

In addition, the invention provides an apparatus for attenuating noise in an input signal, comprising:

means adapted to receive the input signal;

means adapted to estimate the power of the input signal to obtain an input power estimate;

means adapted to determine a noise power value based on the input power estimate, the noise power value corresponding to an estimate of the noise power within the input signal;

means adapted to determine an attenuation factor based on the noise power value; and

means adapted to attenuate the input signal by using the attenuation factor.

The apparatus may be adapted to execute the above-mentioned methods. For example, the means adapted to receive the input signal may be configured to digitize the incoming signal if it is an analog signal.

The means adapted to estimate the power of the input signal may be configured to determine block values for blocks of successive samples. The means may be configured to perform a smoothing on the sequence of received samples and/or on the sequence of determined block values by filtering the sequence of samples or of block values.

The means adapted to determine an attenuation factor may be configured to determine an indicator value which indicates the presence of a wanted signal in the input signal.

The apparatus may be a part of a communication device. The communication device may be a network access module, a mobile or landline telephone, a hands-free system, a portable or stationary radio system or a system for controlling devices via voice control. The apparatus or the communication device may be installed in a vehicular cabin.

Further aspects of the invention will be described below with reference to the attached figures.

Figure 1     illustrates in an exemplary way the steps for attenuating noise;

Figure 2     illustrates an example of a noise power value compared to an input power estimate;

Figure 3     illustrates an example for the progress of quantities over time with a common time base, the quantities being: the input signal amplitude, the input power estimate and the noise power value, the indicator value, the attenuation factor and the output signal amplitude;

Figure 4     illustrates an input signal;

Figure 5     illustrates an example for the characteristics of a noise gate for a gate threshold value of 0.4.

Exemplary embodiments of the invention will be described in the following. In the examples to follow, the wanted signal component in the input signal is assumed to be a speech signal. However, the invention is not limited to this type of wanted signal component.

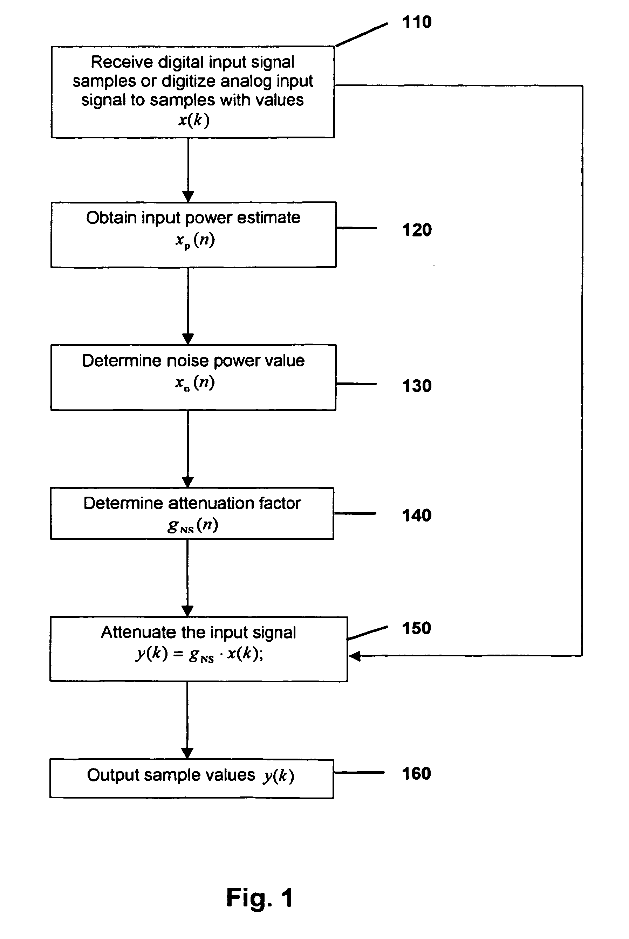

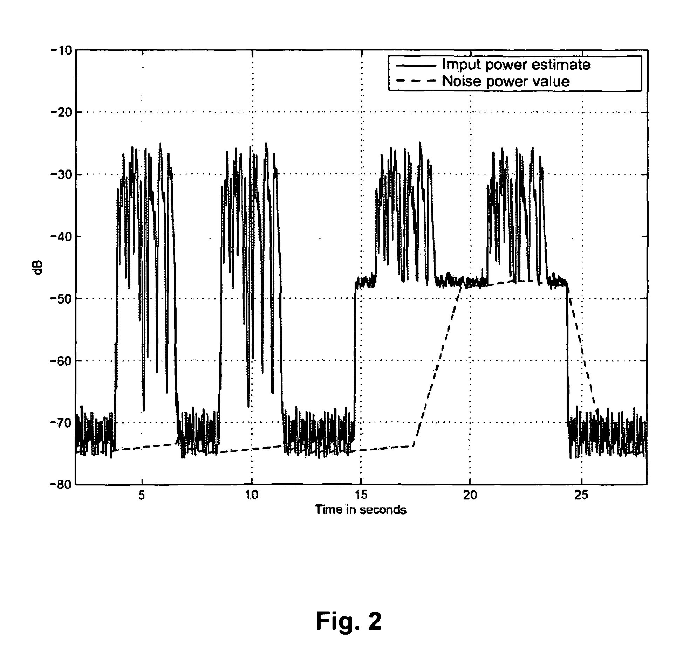

The operation of one embodiment of the invention is illustrated by the flow diagram of Figure 1 in combination with the graphs of Figure 2.

In step **110**, the input signal may be received in the form of a digital or of an analog signal. If the input signal is an analog signal, it may be digitized, resulting in a time-ordered sequence of samples with sample values $x(k)$, where k is the index of the respective sample in the sequence of samples representing the input signal. The index k corresponds to the sample time where the sample value $x(k)$ has been determined.

The samples may be divided into consecutive blocks of $N_{block}$ successive samples. The blocks may be numbered by an index according to their order. In a first step, the average $x_{p,cur}(n)$ of the sample values of the samples in the n-th block (i.e. the block with index n) may be determined and assigned to the n-th block as block value :

$$x_{p,cur}(n) = \frac{1}{N_{block}} \sum_{m=0}^{N_{block}-1} |x(n\,N_{block} - m)|. \tag{1}$$

In step **120**, the sequence of the block values $x_{p,cur}(n)$ may be smoothed using a first order Infinite Impulse Response (IIR) filter characterized by the parameters $\beta_{p,r}$ between 0 and 1 for increasing input signal power and $\beta_{p,f}$ between 0 and 1 for declining input signal power, thus obtaining the input power estimate $x_p(n)$ as:

$$x_P(n) = \begin{cases} \beta_{p,r}\, x_p(n-1) + (1 - \beta_{p,r})\, x_{p,cur}(n), & \text{for } x_{p,cur}(n) > x_p(n-1), \\ \beta_{p,f}\, x_p(n-1) + (1 - \beta_{p,f}) x_{p,cur}(n), & \text{for } x_{p,cur}(n) \leq x_p(n-1). \end{cases} \tag{2}$$

The input power estimate may serve as a basis for deriving the noise power value $x_n(n)$, corresponding to an estimate of the noise power component in the input signal, in step 130:

$$
x_{\mathrm{N}}(n) = \begin{cases}
\beta_{\mathbf{n}} x_{\mathbf{n}}(n-1) + (1-\beta_{\mathbf{n}}) x_{\mathbf{p}}(n), & \text{for } n < n_{\mathbf{init}} \\[4pt]
\max\{\kappa_{\mathbf{dec,f}} x_{\mathbf{n}}(n-1), x_{\mathbf{n,min}}\}, & \text{for } n \geq n_{\mathbf{init}}, \quad x_{\mathbf{n}}(n-1) > x_{\mathbf{p}}(n), \quad \tau_{\mathbf{dec}} > \tau_{\mathbf{dec,th}} \\[4pt]
\max\{\kappa_{\mathbf{dec,s}} x_{\mathbf{n}}(n-1), x_{\mathbf{n,min}}\}, & \text{for } n \geq n_{\mathbf{init}}, \quad x_{\mathbf{n}}(n-1) > x_{\mathbf{p}}(n), \quad \tau_{\mathbf{dec}} \leq \tau_{\mathbf{dec,th}} \\[4pt]
\max\{\kappa_{\mathbf{inc,f}} x_{\mathbf{n}}(n-1), x_{\mathbf{n,min}}\}, & \text{for } n \geq n_{\mathbf{init}}, \quad x_{\mathbf{n}}(n-1) \leq x_{\mathbf{p}}(n), \quad \tau_{\mathbf{inc}} > \tau_{\mathbf{inc,th}} \\[4pt]
\max\{\kappa_{\mathbf{inc,s}} x_{\mathbf{n}}(n-1), x_{\mathbf{n,min}}\}, & \text{for } n \geq n_{\mathbf{init}}, \quad x_{\mathbf{n}}(n-1) \leq x_{\mathbf{p}}(n), \quad \tau_{\mathbf{inc}} \leq \tau_{\mathbf{inc,th}}.
\end{cases} \tag{3}
$$

It can be seen from (3) that, during a predetermined initialization period $n < n_{init}$ with an $n_{init} > 0$, i.e. dealing with blocks with an index $n < n_{init}$, the noise power value is based on the input power estimate, but smoothed by a first order Infinite Impulse Response (IIR) filter characterized by the parameter $\beta_n$. After the predetermined initialization period, the input power value may be limited by the lower limit $x_{n,min}$. At a block index n where the input power estimate is smaller than the noise power value at the preceding block with index n-1, the noise power value may be reduced by a positive factor $\kappa_{dec,f} < 1$ or $\kappa_{dec,s} < 1$ depending on the number of preceding decreases $\tau_{dec}$ being more than a given threshold value $\tau_{dec,th}$, or not. The parameter $\kappa_{dec,s}$ realizes a slow decrease, while $\kappa_{dec,f}$, which is effective after a number $\tau_{dec,th}$ of slow decreases, has the effect of a fast decrease so as to follow larger changes in the input power estimate quickly.

In the case that the input power estimate at a block index n is equal or larger than the noise power value at the preceding block with index n-1, the noise power value may show a corresponding behavior, i.e. the noise power value may be increased by a positive factor $\kappa_{inc,s} > 1$ to cause a small increase when the number of consecutive increases is less or equal than $\tau_{inc,th}$, and the noise power value may be increased by the positive factor $\kappa_{ine,f} > 1$ for a steeper increase after the number of consecutive increases exceeds $\tau_{inc,th}$.

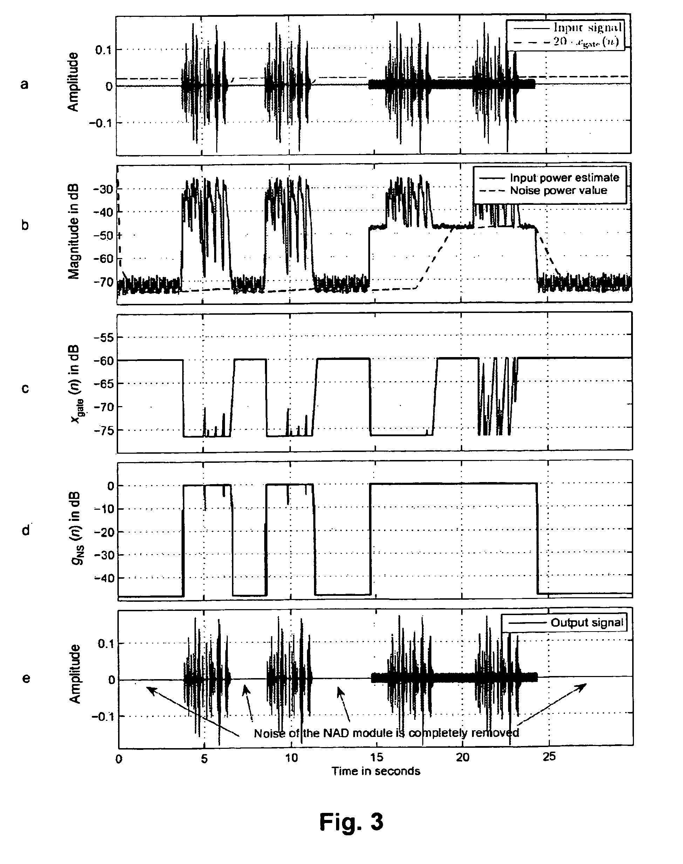

An example of the behavior of the input power estimate and the corresponding noise power value is illustrated in Figures 2 and 3. In Figure 3a, the amplitude of an input signal is shown. Four intervals of speech are recorded, and the level of remote noise has been set to zeroes until a time of 14,5 seconds Then the noise level has been increased to about -47 db in a time interval between 14.5 and 24 seconds. Figures 2 and 3b present the corresponding input power estimate and noise power value. The solid line shows the input power estimate according to equation (2). The dashed line presents the noise power value determined according to equation (3). It can be seen that the noise power value approximates a lower limit of the input power estimate. At a time of about 17.5 seconds, one can observe that the rate with which the noise power value is increased switches from the smaller $\kappa_{inc,s}$ to the larger $\kappa_{inc,f}$ and thus leads to a much steeper incline which continues until a time is reached where the noise power value becomes larger than the input power estimate.

Based on the input power estimate and the noise power value, the attenuation factor may be determined in step **140**. In the exemplary embodiment, the attenuation factor may comprise an indicator value which may be used to discern between periods where the input power estimate of the input signal is higher than the noise power value, multiplied by a sensitivity factor $\alpha > 0$, i.e. where the wanted signal component is predominant, and periods where this is not the case. In this context, the sensitivity factor $\alpha$ may be defined and the criterion may be established that a frame n is assumed to comprise a wanted signal component if the quotient between the input power estimate and the noise power value is greater than the sensitivity factor. Based on this criterion, the indicator value $x_{gate}(n)$ may be defined as follows:

$$
x_{\mathbf{gate}}(n) = \begin{cases}
\max\{x_{\mathbf{gate,min}}, \beta_{\mathbf{gate,f}} x_{\mathbf{gate}}(n-1)\}, & \text{for } x_{\mathbf{p}}(n) > \alpha\, x_{\mathbf{n}}(n) \\[6pt]
\min\{x_{\mathbf{gate,max}}, \beta_{\mathbf{gate,r}} x_{\mathbf{gate}}(n-1)\}, & \text{otherwise.}
\end{cases} \tag{4}
$$

From equation (4), it can be seen that $x_{gate}(n)$ decreases to a minimum value as long as the above criterion is met, i.e. as long as the input power estimate exceeds the product of the noise power value and the sensitivity factor. In this case, the indicator value may be decreased by the positive factor $\beta_{gate,f} < 1$ for each consecutive block n until it reaches a minimum value $x_{gate,min}$ as long as the criterion for the presence of a wanted signal is met by consecutive blocks of samples. If the above criterion is not satisfied, then the indicator value may be increased by the positive factor $\beta_{gate,r} > 1$ for each consecutive block n until an upper limit of $x_{gate,max}$ is reached. Values for $x_{gate,max}$ and $x_{gate,min}$ may be chosen to optimize the behavior of the attenuation factor. The value for the upper limit $x_{\text{gate,max}}$ may be chosen such that no noise is audible in periods where the input signal does not comprise any wanted signal component, while $x_{\text{gate,min}}$ may be selected such that the wanted signal component is not degraded in periods where a wanted signal component is present, even if a small amount of noise may still be audible.

Figure 3c shows the progress of the indicator value according to equation (4) as derived from the values for the input power estimate and the noise power value illustrated in Figure 3b. It can be seen that the indicator value is at or near its upper limit $x_{\text{gate,max}}$ over periods where no speech component is present in the input signal or where the power estimate for the input signal is clearly above the noise power value. At times where the input power estimate for the input signal is close to the noise power value or is even below it, the indicator value quickly falls to its lower limit of $x_{\text{gate,min}}$. The indicator value, multiplied by 20, is also depicted as a dashed line in Figure 3a, showing that it has a high value during periods where the input signal has a low amplitude. With the help of the indicator value, the attenuation factor $g_{\text{NS}}(n)$ may be defined as

$$g_{\text{NS}}(n) = \max\left\{ g_{\text{NS,min}}, \min\left\{ g_{\text{NS,max}}, 1 - \frac{x_{\text{gate}}(n)}{x_{\text{p}}(n)} \right\} \right\}. \tag{5}$$

From equation (5), it can be seen that the behavior of the attenuation factor is similar to that of the indicator value, but with an inverted trend. If a wanted signal component is present in the input signal, then the indicator value falls to low values while the input power estimate increases, and the term $1 - \dfrac{x_{\text{gate}}(n)}{x_{\text{p}}(n)}$ gets close to 1 with the consequence that $\min\left\{ g_{\text{NS,max}}, 1 - \dfrac{x_{\text{gate}}(n)}{x_{\text{P}}(n)} \right\}$ and hence, the attenuation factor get to the upper limit of $g_{\text{NS,max}}$, if the limits $g_{\text{NS,max}}$, $g_{\text{NS,min}}$ are chosen correspondingly. In the absence of a wanted signal component in the input signal, the term $1 - \dfrac{x_{\text{gate}}(n)}{x_{\text{p}}(n)}$ will be close to zero and thus, the attenuation factor tends towards the lower limit of $g_{\text{NS,min}}$. In addition, it can be seen that the smaller the input power estimate $x_{\text{p}}(n)$ is, the stronger is the effect of changes of the indicator value $x_{\text{gate}}(n)$ on the attenuation factor $g_{\text{NS}}(n)$. At times where the input power estimate is high in comparison to the indicator value, changes of the indicator value cause small changes of the attenuation factor. In other words, changes in the indicator value have a stronger effect on the attenuation factor at times with low input power estimate. For this reason, the attenuation factor described by equation (5) is particularly well suited for attenuating noise at times where there is only a weak input signal or no input signal at all.

Figure 3d illustrates the progress of the attenuation factor as described by equation (5). Over periods where the input power estimate is low, the attenuation factor behaves about inversely to the indicator value, i.e. it rises when the indicator value falls, and it falls when the indicator value rises, and it is at a high value when the indicator value is at a low value, and vice versa. Most of time, the attenuation factor is either at its lower limit $g_{\text{NS,min}}$ or at its upper limit $g_{\text{NS,max}}$.

However, at the times where the input power estimate is at a high level over an extended period of time, there is a time interval where the indicator value changes to high values, but the attenuation factor does not react to the change by a corresponding decline. This behavior is due to the fact that, according to the presence of $x_{\text{p}}(n)$ in the nominator of the expression for $g_{\text{NS}}(n)$ in equation (5), the effect of changes in the indicator value is the smaller, the higher the value of $x_{\text{p}}(n)$ is. Hence, the embodiment illustrated in Figure 3 is particularly adapted to attenuating noise where the input power estimate is low. Such a situation may be present if noise has to be attenuated during pauses of a speech signal. This may happen if the input signal is the speech of a speaker over a telephone line, where the noise of the telephone system has to be attenuated during speech pauses. Another situation to which an embodiment of the invention may be applied is attenuating noise in the reproduction of sound by a high quality amplifier, particularly the amplifier of a car stereo system. In this case, noise may be mainly attenuated during passages with low sound level or between two pieces of music.

Having determined the attenuation factor, the input signal may be attenuated by using the attenuation factor in step **150**. The input signal may be attenuated by multiplying the k-th sample value $x(k)$ with the attenuation factor which may be derived from the data block n to which the data sample belongs. In this way, an output signal sample value $y(k)$ (**160**) is obtained as

$$y(k) = g_{\text{NS}}\left(\left\lceil \frac{k}{N_{\text{block}}} \right\rceil\right) x(k). \tag{6}$$

In equation (6), the operator $\lceil \ \rceil$ denotes the next integer number greater or equal to its argument. In this way, the attenuation factor may be applied to the samples of the input signal using the original rate of samples, even if the attenuation factor is derived from blocks of samples of the size $N_{\text{block}}$.

In Figure 3e, the output signal corresponding to the input signal of Figure 3a and generated by the exemplary embodiment discussed above is presented. It can be seen that the noise has been removed from the speech pauses in the periods where the signal level has been low, i.e. in the first 14 seconds and at times later than 24 seconds.

The effect of the attenuation factor $g_{\text{NS}}$ on the input signal $x(k)$ is similar to a scalar version of a Wiener filter. So, in another embodiment, squared values may be used in the attenuation factor, such that $g_{\text{NS}}(n)$ comprises the

quotient $\dfrac{\left|x_{\text{gate}}(n)\right|^2}{\left|x_{\text{p}}(n)\right|^2}$ or $\dfrac{x_{\text{gate}}^2(n)}{x_{\text{p}}^2(n)}$ .

However, the attenuation factor according to equation (6) provides a more gentle suppression characteristic.

It is to be understood that different parts and components of the method and apparatus described above can also be implemented so as to be independent of each other and be combined in different form. Furthermore, the above-described embodiments are to be construed as exemplary embodiments only.

## Claims

1. A method for attenuating noise in an input signal, comprising the steps of:

   (a) receiving the input signal (110);
   (b) estimating the power of the input signal to obtain an input power estimate (120);
   (c) determining a noise power value based on the input power estimate, the noise power value corresponding to an estimate of the noise power within the input signal (130);
   (d) determining an attenuation factor based on the noise power value (140); and
   (e) attenuating the input signal using the attenuation factor (150),

   wherein the input signal is an analog signal or a digital signal, and if the input signal is an analog signal, step (a) comprises digitizing the input signal, and
   wherein the input signal comprises an acoustic wanted signal component, and wherein determining the attenuation factor comprises determining an indicator value indicating the presence of a wanted signal component in the input signal at a given time, wherein the indicator value is increased if the input power estimate at the given time is larger than the product of the noise power value at the given time and a predetermined sensitivity factor, and wherein the indicator value is decreased if the input power estimate at the given time is smaller than the product of the noise power value at the given time and the predetermined sensitivity factor.

2. The method according to claim 1, wherein determining the noise power value comprises determining whether the input power estimate at a given time is larger than the noise power value at a previous time.

3. The method according to one of the preceding claims, wherein determining the noise power value comprises increasing the noise power value at a given time if the input power estimate at the given time is larger than the noise power value at a previous time.

**4.** The method according to one of the preceding claims, wherein determining the noise power value comprises determining the noise power value at a given time based on the noise power value determined at a previous time and multiplied by an adjustment factor.

**5.** The method according to one of the preceding claims, wherein in the step of determining the noise power value, the noise power value is bounded below by a predetermined lower noise limit.

**6.** The method according to one of the preceding claims, wherein, over a predetermined period, the step of determining the noise power value is performed based on the input power estimate smoothed by a filter.

**7.** The method according to one of the preceding claims, wherein determining the attenuation factor is additionally based on the input power estimate.

**8.** The method according to claim 1, wherein the indicator value is bounded above by a predetermined indicator maximum value and/or bounded below by a predetermined indicator minimum value.

**9.** The method according to claim 1 or 8, wherein the attenuation factor is based on the quotient of the indicator value and the input signal estimate and/or the attenuation factor is time dependent.

**10.** The method according to one of the preceding claims, wherein the steps (b) to (e) are repeated at successive points in time.

**11.** The method according to one of the preceding claims, wherein the attenuation factor is bounded below by a predetermined attenuation minimum value and/or bounded above by a predetermined attenuation maximum value and/or the attenuation factor is time dependent.

**12.** Computer program product comprising one or more computer-readable media having computer-executable instructions thereon for performing the steps of the method of one of the preceding claims when run on a computer.

**13.** An apparatus for attenuating noise in an input signal, comprising:

means adapted to receive the input signal;
means adapted to estimate the power of the input signal to obtain an input power estimate;
means adapted to determine a noise power value based on the input power estimate, the noise power value corresponding to an estimate of the noise power within the input signal;
means adapted to determine an attenuation factor based on the noise power value;
means adapted to attenuate the input signal by using the attenuation factor,

wherein the input signal is an analog signal or a digital signal, and the means adapted to receive the input signal are also adapted to digitize the input signal if the input signal is an analog signal, and
wherein the input signal comprises an acoustic wanted signal component, and
wherein the means adapted to determine the attenuation factor comprises determining an indicator value indicating the presence of a wanted signal component in the input signal at a given time, wherein the indicator value is increased if the input power estimate at the given time is larger than the product of the noise power value at the given time and a predetermined sensitivity factor, and wherein the indicator value is decreased if the input power estimate at the given time is smaller than the product of the noise power value at the given time and the predetermined sensitivity factor.

**Patentansprüche**

**1.** Verfahren zum Dämpfen von Rauschen in einem Eingangssignal, das die folgenden Schritte umfasst:

a) Empfangen des Eingangssignals (110);
b) Schätzen der Leistung des Eingangssignals, um einen Eingangsleistungs-Schätzwert (120) zu ermitteln;
c) Bestimmen eines Rauschleistungswertes auf Basis des Eingangsleistungs-Schätzwertes, wobei der Rauschleistungswert einem Schätzwert der Rauschleistung innerhalb des Eingangssignals (130) entspricht;
d) Bestimmen eines Dämpfungsfaktors auf Basis des Rauschleistungswertes (140); und

e) Dämpfen des Eingangssignals unter Verwendung des Dämpfungsfaktors (150),

wobei das Eingangssignal ein analoges Signal oder ein digitales Signal ist, und, wenn das Eingangssignal ein analoges Signal ist, Schritt a) Digitalisieren des Eingangssignals umfasst, und

wobei das Eingangssignal eine akustische, erwünschte Signalkomponente umfasst, und wobei Bestimmen des Dämpfungsfaktors Bestimmen eines Indikatorwertes umfasst, der das Vorhandensein einer erwünschten Signalkomponente in dem Eingangssignal zu einem bestimmten Zeitpunkt anzeigt, wobei der Indikatorwert erhöht wird, wenn der Eingangsleistungs-Schätzwert zu dem bestimmten Zeitpunkt höher ist als das Produkt des Rauschleistungswertes zu dem bestimmten Zeitpunkt und eines vorgegebenen Empfindlichkeitsfaktors, und der Indikatorwert gesenkt wird, wenn der Eingangsleistungs-Schätzwert zu dem bestimmten Zeitpunkt niedriger ist als das Produkt des Rauschleistungswertes zu dem bestimmten Zeitpunkt und des vorgegebenen Empfindlichkeitsfaktors.

2. Verfahren nach Anspruch 1, wobei Bestimmen des Rauschleistungswertes umfasst, dass bestimmt wird, ob der Eingangsleistungs-Schätzwert zu einem bestimmten Zeitpunkt höher ist als der Rauschleistungswert zu einem vorhergehenden Zeitpunkt.

3. Verfahren nach einem der vorangehenden Ansprüche, wobei Bestimmen des Rauschleistungswertes umfasst, dass der Rauschleistungswert zu einem bestimmten Zeitpunkt erhöht wird, wenn der Eingangsleistungs-Schätzwert zu dem bestimmten Zeitpunkt höher ist als der Rauschleistungswert zu einem vorhergehenden Zeitpunkt.

4. Verfahren nach einem der vorangehenden Ansprüche, wobei Bestimmen des Rauschleistungswertes Bestimmen des Rauschleistungswertes zu einem bestimmten Zeitpunkt auf Basis des Rauschleistungswertes zu einem vorhergehenden Zeitpunkt, multipliziert mit einem Anpassungsfaktor, umfasst.

5. Verfahren nach einem der vorangehenden Ansprüche, wobei in dem Schritt des Bestimmens des Rauschleistungswertes der Rauschleistungswert durch eine vorgegebene untere Rauschgrenze nach unten begrenzt wird.

6. Verfahren nach einem der vorangehenden Ansprüche, wobei über einen vorgegebenen Zeitraum der Schritt des Bestimmens des Rauschleistungswertes auf Basis des mittels eines Filters geglätteten Eingangsleistungs-Schätzwertes durchgeführt wird.

7. Verfahren nach einem der vorangehenden Ansprüche, wobei Bestimmen des Dämpfungsfaktors zusätzlich auf dem Eingangsleistungs-Schätzwert basiert.

8. Verfahren nach Anspruch 1, wobei der Indikatorwert durch einen vorgegebenen Indikator-Maximalwert nach oben begrenzt wird und/oder durch einen vorgegebenen Indikator-Minimalwert nach unten begrenzt wird.

9. Verfahren nach Anspruch 1 oder 8, wobei der Dämpfungsfaktor auf dem Quotienten des Indikator-Wertes und des Eingangssignal-Schätzwertes basiert und/oder der Dämpfungsfaktor zeitabhängig ist.

10. Verfahren nach einem der vorangehenden Ansprüche, wobei die Schritte b) bis e) zu aufeinanderfolgenden Zeitpunkten wiederholt werden.

11. Verfahren nach einem der vorangehenden Ansprüche, wobei der Dämpfungsfaktor nach unten durch einen vorgegebenen Dämpfungs-Minimalwert begrenzt wird und/oder nach oben durch einen vorgegebenen Dämpfungs-Maximalwert begrenzt wird und/oder der Dämpfungsfaktor zeitabhängig ist.

12. Computerprogrammerzeugnis, das ein computerlesbares Medium oder mehrere computerlesbare Medien umfasst, das/die durch Computer ausführbare Befehle zum Durchführen der Schritte des Verfahrens nach einem der vorangehenden Ansprüche bei Ausführung auf einem Computer aufweist/aufweisen.

13. Vorrichtung zum Dämpfen von Rauschen in einem Eingangssignal, die umfasst:

eine Einrichtung, die so eingerichtet ist, dass sie das Eingangssignal empfängt;
eine Einrichtung, die so eingerichtet ist, dass sie die Leistung des Eingangssignals schätzt, um einen Eingangsleistungs-Schätzwert zu ermitteln;
eine Einrichtung, die so eingerichtet ist, dass sie einen Rauschleistungswert auf Basis des Eingangsleistungs-Schätzwertes bestimmt, wobei der Rauschleistungswert einem Schätzwert der Rauschleistung innerhalb des Eingangssignals entspricht;

eine Einrichtung, die so eingerichtet ist, dass sie einen Dämpfungsfaktor auf Basis des Rauschleistungswertes bestimmt;

eine Einrichtung, die so eingerichtet ist, dass sie das Eingangssignal unter Verwendung des Dämpfungsfaktors dämpft,

wobei das Eingangssignal ein analoges Signal oder ein digitales Signal ist und die Einrichtung, die so eingerichtet ist, dass sie das Eingangssignal empfängt, des Weiteren so eingerichtet ist, dass sie das Eingangssignal digitalisiert, wenn das Eingangssignal ein analoges Signal ist, und

wobei das Eingangssignal eine akustische, erwünschte Signalkomponente umfasst, und

wobei die Einrichtung, die so eingerichtet ist, dass sie den Dämpfungsfaktor bestimmt,

einen Indikatorwert bestimmt, der das Vorhandensein einer erwünschten Signalkomponente in dem Eingangssignal zu einem bestimmten Zeitpunkt anzeigt, wobei der Indikatorwert erhöht wird, wenn der Eingangsleistungs-Schätzwert zu dem bestimmten Zeitpunkt höher ist als das Produkt des Rauschleistungswertes zu dem bestimmten Zeitpunkt und eines vorgegebenen Empfindlichkeitsfaktors, und der Indikatorwert gesenkt wird, wenn der Eingangsleistungs-Schätzwert zu dem bestimmten Zeitpunkt niedriger ist als das Produkt des Rauschleistungswertes zu dem bestimmten Zeitpunkt und des vorgegebenen Empfindlichkeitsfaktors.

**Revendications**

1. Procédé d'atténuation du bruit dans un signal d'entrée, comprenant les étapes consistant à :

   (a) recevoir le signal d'entrée (110) ;
   (b) estimer la puissance du signal d'entrée pour obtenir une estimation de puissance d'entrée (120) ;
   (c) déterminer une valeur de puissance de bruit basée sur l'estimation de puissance d'entrée, la valeur de puissance de bruit correspondant à une estimation de la puissance de bruit dans le signal d'entrée (130) ;
   (d) déterminer un facteur d'atténuation basé sur la valeur de puissance de bruit (140) ; et
   (e) atténuer le signal d'entrée en utilisant le facteur d'atténuation (150),

   dans lequel le signal d'entrée est un signal analogique ou un signal numérique et si le signal d'entrée est un signal analogique, l'étape (a) comprend la numérisation du signal d'entrée, et
   dans lequel le signal d'entrée comprend une composante désirée de signal acoustique, et
   dans lequel la détermination du facteur d'atténuation comprend la détermination d'une valeur indicatrice indiquant la présence d'une composante désirée de signal dans le signal d'entrée à un temps donné, dans lequel la valeur indicatrice est augmenté si l'estimation de puissance d'entrée au temps donné est plus grande que le produit de la valeur de puissance de bruit au temps donné par un facteur de sensibilité prédéterminé et dans lequel la valeur indicatrice est diminué si l'estimation de puissance d'entrée au temps donné est plus petite que le produit de la valeur de puissance de bruit au temps donné par le facteur de sensibilité prédéterminé.

2. Procédé selon la revendication 1, dans lequel la détermination de la valeur de puissance de bruit comprend la détermination du fait que l'estimation de puissance d'entrée à un temps donné est plus grande que la valeur de puissance de bruit à un temps précédent.

3. Procédé selon l'une des revendications précédentes, dans lequel la détermination de la valeur de puissance de bruit comprend l'augmentation de la valeur de puissance de bruit à un temps donné si l'estimation de puissance d'entrée au temps donné est plus grande que la valeur de puissance de bruit à un temps précédent.

4. Procédé selon l'une des revendications précédentes, dans lequel la détermination de la valeur de puissance de bruit comprend la détermination de la valeur de puissance de bruit à un temps donné basé sur la valeur de puissance de bruit déterminée à un temps précédent et multipliée par un facteur d'ajustement.

5. Procédé selon l'une des revendications précédentes, dans lequel à l'étape de détermination de la valeur de puissance de bruit, la valeur de puissance de bruit est limitée en bas par une limite de bruit inférieure prédéterminée.

6. Procédé selon l'une des revendications précédentes, dans lequel, pendant une période prédéterminée, l'étape de détermination de la valeur de puissance de bruit est effectuée en se basant sur l'estimation de puissance d'entrée lissée par un filtre.

**7.** Procédé selon l'une des revendications précédentes, dans lequel la détermination du facteur d'atténuation est basée de plus sur l'estimation de puissance d'entrée.

**8.** Procédé selon la revendication 1, dans lequel la valeur indicatrice est limitée en haut par une valeur maximale d'indicateur prédéterminée et/ou est limitée en bas par une valeur minimale d'indicateur prédéterminée.

**9.** Procédé selon la revendication 1 ou 8, dans lequel le facteur d'atténuation est basé sur le quotient de la valeur indicatrice par l'estimation de signal d'entrée et/ou le facteur d'atténuation dépend du temps.

**10.** Procédé selon l'une des revendications précédentes, dans lequel les étapes (b) à (e) sont répétées à des instants successifs dans le temps.

**11.** Procédé selon l'une des revendications précédentes, dans lequel le facteur d'atténuation est limitée en bas par une valeur minimale d'atténuation prédéterminée et/ou est limitée en haut par une valeur maximale d'atténuation prédéterminée et/ou le facteur d'atténuation dépend du temps.

**12.** Produit de programme informatique comprenant un ou plusieurs supports lisibles par un ordinateur comportant sur ceux-ci des instructions exécutables par un ordinateur pour effectuer les étapes du procédé selon l'une des revendications précédentes, lorsqu'il est exécuté sur un ordinateur.

**13.** Dispositif d'atténuation du bruit dans un signal d'entrée, comprenant :

un moyen adapté à recevoir le signal d'entrée ;
un moyen adapté à estimer la puissance du signal d'entrée pour obtenir une estimation de puissance d'entrée ;
un moyen adapté à déterminer une valeur de puissance de bruit basée sur l'estimation de puissance d'entrée, la valeur de puissance de bruit correspondant à une estimation de la puissance de bruit dans le signal d'entrée ;
un moyen adapté à déterminer un facteur d'atténuation basé sur la valeur de puissance de bruit ;
un moyen adapté à atténuer le signal d'entrée en utilisant le facteur d'atténuation,
dans lequel le signal d'entrée est un signal analogique ou un signal numérique et le moyen adapté à recevoir le signal d'entrée est également adapté à numériser le signal d'entrée si le signal d'entrée est un signal analogique, et
dans lequel le signal d'entrée comprend une composante désirée de signal acoustique, et
dans lequel le moyen adapté à déterminer le facteur d'atténuation comprend la détermination d'une valeur indicatrice indiquant la présence d'une composante désirée de signal dans le signal d'entrée à un temps donné, dans lequel la valeur indicatrice est augmenté si l'estimation de puissance d'entrée au temps donné est plus grande que le produit de la valeur de puissance de bruit au temps donné par un facteur de sensibilité prédéterminé et dans lequel la valeur indicatrice est diminué si l'estimation de puissance d'entrée au temps donné est plus petite que le produit de la valeur de puissance de bruit au temps donné par le facteur de sensibilité prédéterminé.

**Fig. 1**

**Fig. 2**

**Fig. 3**

**Fig. 4a**

**Fig. 4b**

**Fig. 4c**

**Fig. 5**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090010452 A

- US 4628529 A